(19) Europäisches Patentamt
European Patent Office
Office européen des brevets

(11) **EP 2 242 141 A1**

(12) **EUROPEAN PATENT APPLICATION**

(43) Date of publication:
**20.10.2010 Bulletin 2010/42**

(51) Int Cl.:
*H01P 1/203* (2006.01)   *H01P 1/20* (2006.01)

(21) Application number: **09290284.0**

(22) Date of filing: **17.04.2009**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(71) Applicant: **Alcatel Lucent**
**75008 Paris (FR)**

(72) Inventor: **Merk, Thomas**
**70736 Fellbach (DE)**

(74) Representative: **Michalski Hüttermann & Partner Patentanwälte**
**Neuer Zollhof 2**
**40221 Düsseldorf (DE)**

(54) **Electronic circuit for RF applications and corresponding power amplifier**

(57) The present invention relates to an electronic circuit (10) for radio frequency applications comprising a power transistor (12) and a feeding path (14) between a voltage source and a drain electrode (16) of the power transistor (12) for electrically supplying said power transistor (12). According to the invention the feeding path (14) comprises a parallel circuit (18) of at least one capacitive element (20) and a transmission line (22) interconnected in parallel.

The invention further relates to a corresponding power amplifier for radio frequency applications.

Fig. 1

EP 2 242 141 A1

**Description**

The present invention relates to an electronic circuit for radio frequency applications comprising a power transistor and a feeding path between a voltage source and a drain electrode of the power transistor for power supplying said power transistor.

The electronic circuit for RF applications (RF: radio frequency) is for example a RF power amplifier. Such power amplifiers are widely employed in the telecommunication applications, such as UMTS (UMTS: Universal Mobile Telecommunications System). The power amplifier typically comprises an amplifier transistor stage with a power transistor and a feeding circuit comprising the DC feeding path (DC: direct current) between the voltage source and the drain electrode of the power transistor. To achieve an almost linear amplification, the non-linearity of the power transistor is compensated by a linearization system using a pre-distortion algorithm.

As a standard design rule for power amplifiers the feeding path for supplying the power transistor is a so called quarter-wave line (λ/4 line) through which the electrical current is supplied for the transistor. The length of this straight quarter-wave line is dependent on the RF-frequency band of the electronic circuit - the lower the RF-frequency, the longer a corresponding wavelength of a wave passing the line and the longer the quarter-wave line itself. For low frequency signals which are modulated onto the RF-carrier signal this quarter-wave-line is more or less a resistive and inductive line - the longer the quarter-wave line, the bigger the resistance and inductance of this quarter-wave line. In most RF applications the low frequency impedance has to be as low as possible to get the current into the transistor as fast as possible - ideally without any time-delay. If there is a certain impedance in the drain feeding path, it prevents the current to flow into the transistor at the point of time when it is required, this effect is a so-called "electrical memory effect" which makes it harder for a linearization system to linearize the power amplifier.

Currents solutions use quarter-wave feeding lines or even little shorter feeding lines with a low characteristic impedance, but the lines cannot be shorter than approximately an eighths of the wavelength corresponding to the RF-frequency band. To provide low impedance at low frequencies these lines have to become very large and therefore very space-consuming on a printed-circuit board.

It is the object of the invention to provide an electronic circuit for radio frequency applications comprising a power transistor and a feeding path between a voltage source and a drain electrode of the power transistor which overcomes the aforementioned disadvantages.

This object is achieved by the present invention as defined in claim 1. The feeding path of the electronic circuit comprises a parallel circuit of at least one capacitive element and a transmission line interconnected in parallel. The electrical current is supplied to the transistor through said transmission line. The radio frequency application gives a concrete RF-range the electronic circuit is designed for. The capacitive element and the transmission line provide a parallel resonance with a resonance frequency $f_0$ in said RF-range given by the capacitance C and the inductance L of the transmission line (due to its inductance) of the parallel circuit with:

$$f_0 = \frac{1}{2\pi\sqrt{LC}}$$

Such a combination of the capacitor and the short line provides a parallel resonance (high impedance) at the designated RF-frequency band and -due to the very short transmission line-low impedance at low frequencies.

In most RF applications the low frequency impedance has to be as low as possible to get the current into the transistor without significant time-delay. If there is certain impedance in the drain feeding path, it avoids a current flow into the transistor in time; this effect is called electrical memory effect. The feeding path of the electronic circuit comprises a parallel circuit of at least one capacitive element and a short line. This arrangement reduces electrical memory effects and therefore improves the ability to linearize the electronic circuit. This is especially necessary in applications with very stringent spectral requirements, especially GSM-Multicarrier transmitters (GSM: Global System for Mobile communications). The advantage of the feeding path according to the invention over a standard quarter-wave line solution is the reduced low frequency impedance and therefore the lower memory effects caused by this type of drain feeding network. Additionally the new solution needs less space on a printed circuit board. The capacitive element of the parallel circuit preferably is a capacitor. This capacitor dominates the capacitive characteristics of the parallel circuit.

Preferably the RF-range is a frequency range in the ultra high frequency (UHF) range from 300 to 3000 MHz (corresponding wavelength λ = 10 - 100 cm) or super high frequency (SHF) range from 3 to30 GHz (λ = 1-10 cm).

Especially the total expansion of the feeding line is ≤ 1/8 of the corresponding wavelength λ, preferably ≤ 1/16 λ.

According to a preferred embodiment of the invention, the transmission line is a U-shaped transmission line. The parallel circuit with a U-shaped transmission line is formed as a lumped network. Especially the capacitive element is electrically connected to end sections of the arms of the U-shaped transmission line. A parallel circuit with a U-shaped transmission line and the capacitive element electrically connected to the end sections of the arms of said U-shaped transmission line can be formed as a parallel circuit with very low expansion.

According to another preferred embodiment of the invention, the transmission line is formed integrally with at least one further line member of the feeding path and/or a RF output line of the power transistor. Preferably the transmission line and/or the further line member and/or the RF output line of the power transistor are integrally formed parts of a printed circuit board.

According to yet another preferred embodiment of the invention, the further line member constitutes a first connection for connecting the voltage source. Preferably the transmission line and/or the further line member and/or the RF output line of the power transistor are integrally formed parts of a printed circuit board.

According to another preferred embodiment of the invention, the electronic circuit further comprises at least one capacitive decoupling device for decoupling of AC signal components in the feeding path. Especially, the capacitive decoupling device connects the further line member and ground potential. Preferably the electronic circuit comprises a cascade of capacitive decoupling devices for decoupling the AC signal components in the feeding path.

The invention further relates to a power amplifier for radio frequency applications comprising the aforementioned electronic circuit. The power amplifier typically comprises an amplifier transistor stage with the power transistor and the feeding circuit comprising the DC feeding path (DC: direct current) between the voltage source and the drain electrode of the power transistor. To achieve an almost linear amplification the non-linearity of the power transistor is compensated by a linearization system, preferably using a pre-distortion algorithm.

These and other aspects of the invention will be apparent from and elucidated with reference to the embodiments described hereinafter.

In the drawings:

Fig. 1 shows an electronic circuit for radio frequency applications comprising a power transistor and a feeding path;

Fig. 2 shows the simulated impedance of the electronic circuit in a frequency range from 10 kHz to 1 GHz; and

Fig. 3 depicts simulation results comparing the ability to linearize a power amplifier using an electronic circuit with a feeding path consisting of a quarter-wave line and a feeding path in accordance with the invention.

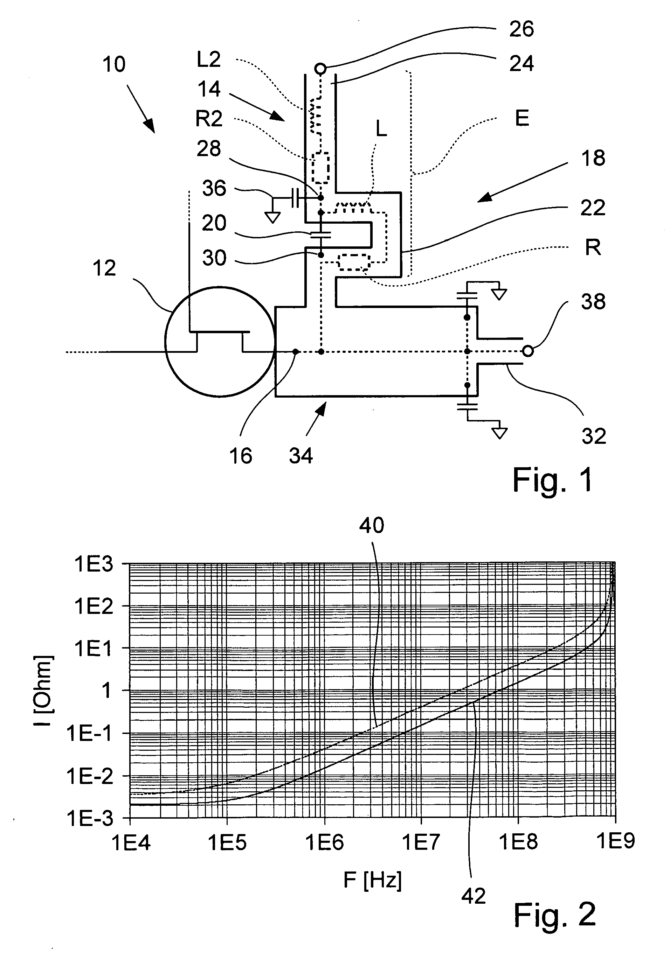

Fig. 1 depicts an electronic circuit 10 for radio frequency applications comprising a power transistor 12 and a feeding network with a feeding path 14 between a voltage source (not shown) and a drain electrode 16 of the power transistor 12. The feeding path 14 comprises of a parallel circuit 18 consisting of a capacitive element 20 and a transmission line 22 and a further line member 24 which forms a connection 26 to the voltage source. The capacitive element 20 is a capacitor which is electrically connected to end sections 28, 30 of the arms of the U-shaped transmission line 22. The transmission line 22 is connected to a RF-output line 32 of the circuit 10 and the drain electrode 16 of the power transistor 12. The RF-output line 32, the transmission line 22 and the further line member 24 are integrally formed printed circuit board tracks of a printed circuit board. The parallel circuit 18 is arranged between the further line member 24 and a connection area 34 of the RF-output line 32, the drain electrode 16 and an end section of the transmission line 22. A capacitive decoupling device 36 for decoupling of AC signal components in the feeding path 14 is connected between the further line member 24 and a reference potential (ground potential). The components are components of a signal carrier frequency. Preferably a cascade of capacitive decoupling devices 36 is connected in parallel between the further line member 24 and a reference potential (not shown). The RF-output line 32 forms a RF-output connection 38. The electronic circuit 10 is an electronic circuit of a RF power amplifier.

The extent E of the feeding path 14 can be chosen much smaller than an eighth of the wavelength $\lambda$. In the example of Figs. 1 to 3 the RF frequency is 942 MHz and the corresponding wavelength is 31.8 cm ($\lambda$ = 31.8 cm); an eighth of the wavelength is about 4 cm. Therefore the extent E of the feeding path 14 according to the invention can be chosen much smaller than 4 cm (<< 4 cm) for this application.

More general the total expansion (or extent E) of the feeding path 14 is $\leq$ 1/8 of the wavelength corresponding to the radio frequency range of the radio frequency application, wherein said radio frequency range is in the ultra high frequency (UHF) range with a corresponding wavelength from 10 to 100 cm or super high frequency (SHF) range with a corresponding wavelength from 1 to 10 cm.

Fig. 1 further shows an equivalent circuit (dashed lines) of the feeding path 14, wherein a serial connection of a first resistance R and a first inductance L represents the transmission line 22 and a serial connection of a second resistance R2 and a second inductance L2 represents the further line member 24.

Fig. 2 depicts a comparison of the impedance I towards the DC-supply seen by the transistor between an electronic circuit comprising a feeding path consisting of a quarter-wave line (upper curve 40) and an electronic circuit 10 according to the invention in the frequency range of 10 kHz to 1.0 GHz. On the one hand the electrical circuit 10 according to the invention (lower curve 42) shows significantly lower impedance at low frequencies and on the other hand it provides very high impedance at the RF frequency (in this case 942MHz) of the power amplifier due to the parallel resonance of the capacitive element 20 (capacitor) and the transmission line 22.

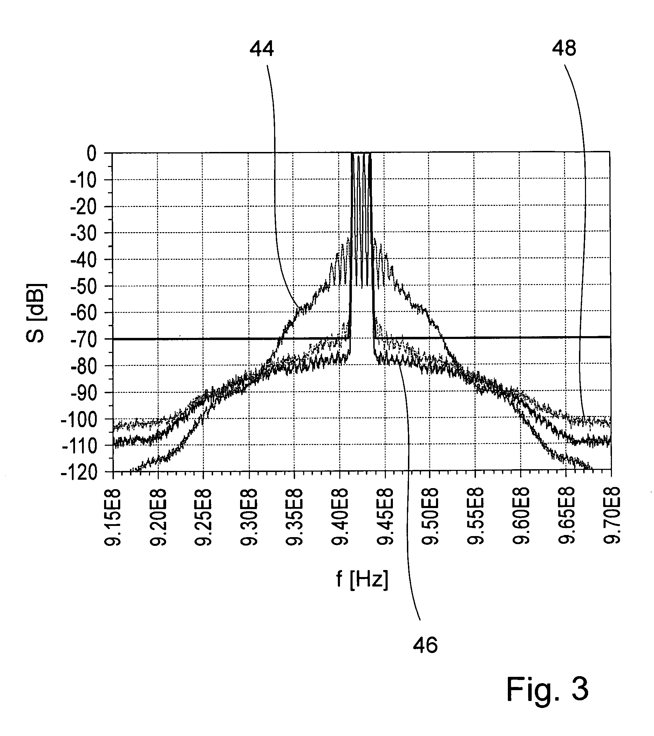

Fig. 3 shows three different spectra S (curves 44, 46, 48) versus the frequency f characterizing the power amplifier. The spectra are simulation results comparing the ability to linearize a power amplifier using a feeding path consisting of a quarter-wave line and a feeding path 14 in accordance with the invention. The curve 44 shows the distorted spectrum caused by the nonlinearities of the power amplifier. After applying a digital pre-distortion algorithm one can see the influence of the new drain feeder (curve 46) with the feeding path 14 comprising a parallel circuit 18 of at least one capacitive element 20 and a transmission line 22 interconnected in parallel the power amplifier. The transfer function of the power transistor 12 can be linearized significantly better than with a conventional quarter-wave drain feed path (curve 48) due to reduced electrical memory effects (the curve 46 is below the curve 48 in the spectral region of interest of 925 MHz to 960 MHz, which means less spectral distortions).

While the invention has been illustrated and described in detail in the drawings and foregoing description, such illustration and description are to be considered illustrative or exemplary and not restrictive; the invention is not limited to the disclosed embodiments.

Other variations to be disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting scope.

**Claims**

1. An electronic circuit (10) for radio frequency applications comprising a power transistor (12) and a feeding path (14) between a voltage source and a drain electrode (16) of the power transistor (12) for power supplying said power transistor (12), **characterised in that** the feeding path (14) comprises a parallel circuit (18) of at least one capacitive element (20) and a transmission line (22) interconnected in parallel.

2. The electronic circuit according to claim 1, wherein the transmission line (22) is a U-shaped transmission line (22).

3. The electronic circuit according to claim 2, wherein the capacitive element (20) is electrically connected to end sections (28, 30) of the arms of the U-shaped transmission line (22).

4. The electronic circuit according to claim 1, wherein the transmission line (22) is formed integrally with at least one further line member (24) of the feeding path (14) and/or a RF-output line (32) of the power transistor (12).

5. The electronic circuit according to claim 4, wherein the transmission line (22) and/or the further line member (24) and/or the RF output line (32) of the power transistor (12) are integrally formed parts of a printed circuit board.

6. The electronic circuit according to claim 4, wherein the further line member (24) constitutes a connection (26) for connecting the voltage source.

7. The electronic circuit according to claim 1, wherein the electronic circuit (10) further comprises at least one capacitive decoupling device (36) for decoupling of AC signal components in the feeding path (14).

8. The electronic circuit according to claim 7, wherein the electronic circuit (10) comprises a cascade of capacitive decoupling devices (34) for decoupling the AC signal components in the feeding path (14).

9. A power amplifier for radio frequency applications comprising the electronic circuit (10) according to one of the preceding claims.

Fig. 1

Fig. 2

Fig. 3

Europäisches
Patentamt

European
Patent Office

Office européen
des brevets

## EUROPEAN SEARCH REPORT

**Application Number**

EP 09 29 0284

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | EP 1 347 572 A (MATSUSHITA ELECTRIC IND CO LTD [JP]) 24 September 2003 (2003-09-24) <br> * figure 1 * <br> * paragraphs [0025] - [0030] * <br> ----- | 1-9 | INV. <br> H01P1/203 <br> H01P1/20 |
| A | DE 10 2008 014930 A1 (INFINEON TECHNOLOGIES AG [DE]) 25 September 2008 (2008-09-25) <br> * figures 1-4 * <br> * paragraphs [0003], [0004] * <br> * paragraphs [0008] - [0013] * <br> * paragraph [0030] * <br> ----- | 1-9 | |
| A | US 5 939 939 A (GAYNOR MICHAEL P [US] ET AL) 17 August 1999 (1999-08-17) <br> * figures 5-7 * <br> * column 3, line 12 - column 6, line 14 * <br> ----- | 1-9 | |
| A | EP 1 058 337 A (MURATA MANUFACTURING CO [JP]) 6 December 2000 (2000-12-06) <br> * abstract; figures 1,2 * <br> * paragraphs [0013] - [0016] * <br> ----- | 1-9 | TECHNICAL FIELDS SEARCHED (IPC) <br> H01P <br> H03F |

The present search report has been drawn up for all claims

| Place of search | Date of completion of the search | Examiner |
|---|---|---|
| Munich | 28 August 2009 | Unterberger, Michael |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

EP 2 242 141 A1

## ANNEX TO THE EUROPEAN SEARCH REPORT
## ON EUROPEAN PATENT APPLICATION NO.

EP 09 29 0284

This annex lists the patent family members relating to the patent documents cited in the above-mentioned European search report.
The members are as contained in the European Patent Office EDP file on
The European Patent Office is in no way liable for these particulars which are merely given for the purpose of information.

28-08-2009

| Patent document cited in search report | | Publication date | Patent family member(s) | | Publication date |
|---|---|---|---|---|---|
| EP 1347572 | A | 24-09-2003 | WO 02054585 A1 | | 11-07-2002 |
| | | | JP 2002204133 A | | 19-07-2002 |
| | | | US 2004027204 A1 | | 12-02-2004 |
| DE 102008014930 A1 | | 25-09-2008 | US 2008231373 A1 | | 25-09-2008 |
| US 5939939 | A | 17-08-1999 | NONE | | |
| EP 1058337 | A | 06-12-2000 | DE 60028867 T2 | | 16-11-2006 |
| | | | JP 3402258 B2 | | 06-05-2003 |
| | | | JP 2000349517 A | | 15-12-2000 |
| | | | US 6864760 B1 | | 08-03-2005 |

EPO FORM P0459

For more details about this annex : see Official Journal of the European Patent Office, No. 12/82

8